# EUROPEAN PATENT SPECIFICATION

(11) **EP 3 281 205 B1**
(45) Date of publication and mention of the grant of the patent: **21.08.2019**
(21) Application number: 16718574.3
(22) Date of filing: 07.04.2016
(51) Int. Cl.: H01B 1/22, H05K 9/00, B29L 31/34, B29K 105/00, H01B 1/24, B29C 48/10, B29C 48/21, B29C 48/00

(54) **ARTICLE WITH COMPOSITE SHIELD AND PROCESS OF PRODUCING AN ARTICLE WITH A COMPOSITE SHIELD**
ARTIKEL MIT EINER ZUSAMMENGESETZTEN ABSCHIRMUNG UND VERFAHREN ZUR HERSTELLUNG EINES ARTIKELS MIT EINER ZUSAMMENGESETZTEN ABSCHIRMUNG
ARTICLE AVEC BLINDAGE COMPOSITE ET PROCESSUS DE FABRICATION D'UN ARTICLE AVEC UN BLINDAGE COMPOSITE

(30) Priority: 10.04.2015 US 201514684266
(43) Date of publication of application: 14.02.2018
(73) Proprietor: TE Connectivity Corporation, Berwyn, PA 19312 (US); Tyco Electronics UK Ltd., Wiltshire SN3 5HH (GB)
(72) Inventor: WANG, Jialing, Mountain View, California 94043 (US); HANSEN, Erling, Redwood City, CA 94063 (US); WARTENBERG, Mark, F., Redwood City, CA 94062 (US); KURUP, Sreeni, Linden Swindon SN3 6EY (GB); LLOYD, Richard, B., Sunnyvale, CA 94089 (US); GAO, Ting, Palo Alto, CA 94306 (US); ROBISON, Jennifer, L., San Mateo, CA 94403 (US)
(74) Representative: Johnstone, Douglas Ian
(86) International application number: PCT/US2016/026499
(87) International publication number: WO 2016/164620

(56) References cited:
- WO-A2-2012/092200
- US-A1- 2004 020 674
- US-A1- 2012 107 538

## Description

### FIELD OF THE INVENTION

The present invention is directed to articles with composite shields and processes of producing such articles. More particularly, the present invention is directed to heat-recoverable and heat-recovered composite shields.

### BACKGROUND OF THE INVENTION

In general, cable shielding materials can be metallic or include ferrites. Metallic shields come in the form of braids, tapes, tubular, spiral, knitted wire mesh with a plastic cover, laminates, plated yarns and fabrics, and many more arrangements. Such shields provide shielding effect for low frequency applications, but they have several drawbacks. For example, braids have diminishing shielding effectiveness in high frequency ranges due to poor optical coverage. Metallic shields can be heavy and/or require costly and complex plating processes. Ferrite beads are used for high frequency noise suppression, but they can be limited by the frequency range that the specific type of ferrite allows and are not suitable for high frequency signal devices.

Conductive shrinkable shields in the form of a regular heat-shrink tubing and a conductive inner layer, such as a metalized fabric layer or silver or silver-coated copper ink or paste, can be used in shielding. Such shielding is expensive, has poor adhesion, has inhomogeneity, does not fit with certain shape objects to be shielded, and is often difficult to terminate and ground. WO 2012/092200 discloses a thermoplastic material for EMI shielding comprising metal conductive fibers. US 2004/020674 discloses EMI shielding composites comprising a matrix with conductive particles dispersed therein. US 2012/107538 discloses EMI shielding thermoset material comprising conductive particles dispersed therein.

An article with a composite shield and a process of producing an article with a composite shield that show one or more improvements in comparison to the prior art would be desirable in the art.

### BRIEF DESCRIPTION OF THE INVENTION

In an embodiment, an article includes a conductive heat-recoverable composite shield. The conductive composite shield comprises a non-conductive matrix and conductive particles within the non-conductive matrix. The article has a resistivity of less than 0.05 ohm·cm. The conductive particles have a morphology of dendrites, flakes or spheres.

In another embodiment, an article includes a conductive heat-recovered composite shield formed from a conductive heat-recoverable composite shield. The heat-recoverable conductive composite shield comprises a non-conductive matrix and conductive particles within the non-conductive matrix. The article has a resistivity of less than 0.05 ohm·cm. The conductive particles have a morphology of dendrites, flakes or spheres.

In another embodiment, a process of producing a conductive heat-recovered composite shield includes extruding a conductive heat-recoverable composite shield and heating the conductive heat-recoverable composite shield thereby forming the conductive heat-recovered composite shield. The heat-recoverable conductive composite shield comprises a non-conductive matrix and conductive particles within the non-conductive matrix. The article has a resistivity of less than 0.05 ohm·cm. The conductive particles have a morphology of dendrites, flakes or spheres.

Other features and advantages of the present invention will be apparent from the following more detailed description, taken in conjunction with the accompanying drawings which illustrate, by way of example, the principles of the invention.

### BRIEF DESCRIPTION OF THE DRAWINGS

FIG. 1 is a schematic view of an embodiment a process of producing coextruded conductive heat-recovered composite shield formed by heating an embodiment of conductive heat-recoverable composite shield, according to the disclosure.
FIG. 2 is a schematic view of an embodiment a process of producing tandem-extruded conductive heat-recovered composite shield formed by heating an embodiment of conductive heat-recoverable composite shield, according to the disclosure.
FIG. 3 is a graphical representation of tensile strength on the y-axis in MPa versus elongation of heat-recoverable composite shield on the x-axis in percent, according to embodiments of the disclosure.
FIG. 4 is a graphical representation of shielding effectiveness on the y-axis in dB of a heat-recoverable composite shield and frequency on the x-axis in GHz, according to an embodiment of the disclosure.
FIG. 5 is a graphical comparative representation of resistivity and contact resistance of an embodiment of a heat-recoverable composite shield, according to the disclosure.

Wherever possible, the same reference numbers will be used throughout the drawings to represent the same parts.

### DETAILED DESCRIPTION OF THE INVENTION

Provided are an article with a composite shield and a process of producing an article with a composite shield. Embodiments of the present disclosure, for example, in comparison to concepts failing to include one or more of the features disclosed herein, permit increases in shielding of electronic components, permit increased shielding effectiveness in high and low frequency ranges, permit flexibility, permit decreased resistivity, permit decreased fabrication costs, permit reduction of weight of articles including such composite shields instead of alternative shielding mechanisms, permit heat-recoverable materials to be secured without an adhesive adversely increasing resistivity, permit other suitable advantages and distinctions, and permit combinations thereof.

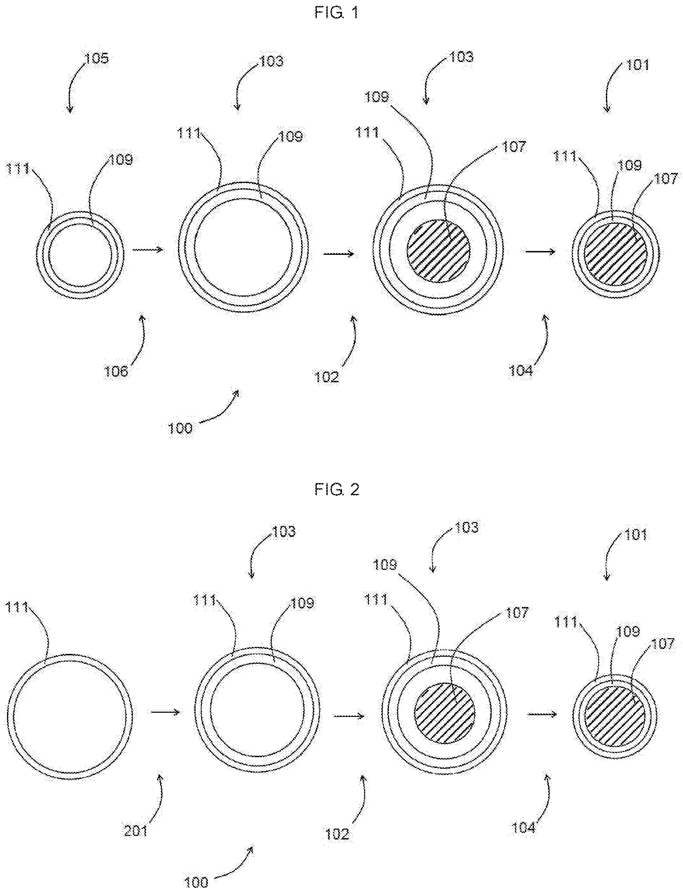

FIG. 1 shows a process 100 of producing a conductive heat-recovered composite shield 101 that forms a portion or entirety of an article, such as, a tube, a sheet, a sleeve, an end cap, a tape, another suitable heat-recovered product, or a combination thereof. As used herein, the term "shield" is intended to reference an independent structure or portion of an independent structure. It is not intended to encompass coatings or such layers positioned on another structure. The process 100 includes extruding (step 102) a conductive heat-recoverable composite shield 103, for example as in co-extruding, over a conductor 107 (such as, a wire or cable), as is illustrated by FIG. 1 or tandem-extruding 201 as is shown in FIG. 2. The conductive heat-recoverable shield 103 is capable of being heated (step 104) to produce the conductive heat-recovered composite shield 101.

In a further embodiment, the process 100 includes forming the heat-recoverable composite shield 103, for example, by electron beaming (step 106) of a precursor 105, such as, a co-extrusion (for example, a dual-wall co-extrusion of identical or similar polymeric materials having identical or similar coefficients of thermal expansion positioned as an inner layer 109 and an outer layer 111) followed by expanding the precursor 105, thereby forming the heat-recoverable composite shield 103, and the heating (step 104) that co-heats the co-extrusion without breaking. Alternatively, the precursor 105 is an injection molding, a tandem-extrusion, or an additively-produced material.

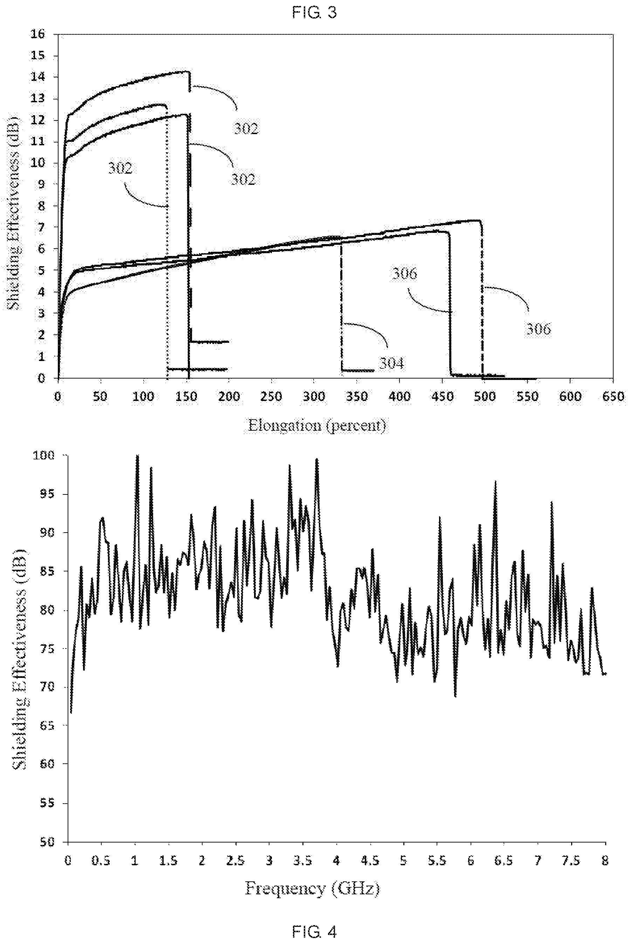

A suitable dosage for the electron beaming (step 106) is below 15 MRad. In one embodiment, the electron beaming (step 106) slightly increases crystallinity of certain polymers within the precursor 105 and, thus, slightly decreases the percolation threshold, thereby resulting in a slightly increased conductivity and shielding effectiveness for embodiments of the heat-recoverable conductive composite shield 103. For example, in one embodiment, the electron beaming (step 106) is at a dose of between 5 Mrad and 7 Mrad (for example, 6 Mrad) on polyvinylidene fluoride (PVDF). The corresponding increase in crystallinity is greater than 0.3%, greater than 0.5%, between 0.3% and 1%, between 0.5% and 1%, between 0.5% and 0.7%, or any suitable combination, sub-combination, range, or sub-range therein, for example, from 55.9% with a standard deviation of 1.1% un-beamed (302) to 56.5% with a standard deviation of 2.7% beamed (304). Referring to FIG. 4, the corresponding increase in shielding effectiveness of the heat-recoverable conductive composite shield 103 after the electron beaming is between 7 and 10 dB, for example, as tested by ASTM D4935, Standard Test Method for Measuring the Electromagnetic Shielding Effectiveness of Planar Materials.

The conductive particles of the heat-recoverable conductive composite shield 103 are or include copper particles, tin particles, nickel particles, aluminum particles, carbon particles, carbon black, carbon nanotubes, graphene, silver-coated particles, nickel-coated particles, other suitable conductive particles compatible with the non-conductive matrix, or a combination thereof. Morphologies for the conductive particles are dendrites, flakes, and spheres. In one embodiment, the conductive particles are or include copper flakes and dendrites, for example, at a relative volume concentration of between 30% and 50% (for example, 40%) higher aspect ratio particles, such as copper flakes having average sizes of between 10 micrometers and 60 micrometers, and 40% and 70% (for example, 60%) lower aspect ratio particles, such as copper dendrites having average sizes of between 20 micrometers and 30 micrometers. In another embodiment, the conductive particles are or include copper dendrites, having average sizes of between 20 micrometers and 30 micrometers, at a relative volume concentration of between 40% and 70% (for example, 60%), and tin spheres, having average sizes of between 8 micrometers and 16 micrometers, at a relative volume concentration of between 30% and 50% (for example, 40%).

In one embodiment, the concentration of the conductive particles within the non-conductive matrix is above the percolation threshold, which is lower for semicrystalline polymers than amorphous polymers due to the semicrystalline polymers including more efficient filler network formation around polymer crystallites. Additionally or alternatively, in one embodiment, the concentration of the conductive particles within the non-conductive matrix is below a recrystallization-limiting threshold. As used herein, the phrase "recrystallization-limiting threshold" refers to a concentration of the conductive particles within the non-conductive matrix at which the cooling after melt-mixing during the process 100 would not permit a substantially equivalent reformation of crystals in the non-conductive matrix.

Suitable volume concentrations of the conductive particles within the non-conductive matrix include between 20% and 40% total loading, between 20% and 35% total loading, between 25% and 40% total loading, between 25% and 35% total loading, between 28% and 32% total loading, between 29% and 31% total loading, or any suitable combination, sub-combination, range, or sub-range therein.

In embodiments with the precursor 105 being the co-extrusion or the tandem-extrusion, the material of the non-conductive matrix is selected based upon tensile strength (for example, based upon ASTM D638, Standard Test Method for Tensile Properties of Plastics) and/or elongation at break. A polymer base of the conductive heat-recoverable composite shield 103 and/or the precursor 105 impacts the tensile strength at break and elongation at break.

For example, in one embodiment, the PVDF is in the conductive heat-recoverable composite shield 103 and/or the precursor 105 as a polymer base, and the tensile strength at break of the heat-recoverable conductive composite shield 103 is between 10 MPa and 20 MPa (for example, between 12 MPa and 15 MPa as shown in PVDF plots 302 of FIG. 3 and/or the elongation at break is between 100% and 200% (for example, between 130% and 160% as shown in FIG. 3).

In one embodiment, tetrafluoroethylene, hexafluoropropylene and vinylidene fluoride (THV) is in the conductive heat-recoverable composite shield 103 and/or the precursor 105 as a polymer base, and the tensile strength at break of the heat-recoverable conductive composite shield 103 is between 4 MPa and 8 MPa (for example, between 6 MPa and 7 MPa as shown in THV plots 304 of FIG. 3) and/or the tensile elongation at break is between 300% and 400% (for example, between 320% and 350% as shown in FIG. 3).

In one embodiment, polyethylene (PE) (for example, linear low-density polyethylene (LLDPE)) is in the conductive heat-recoverable composite shield 103 and/or the precursor 105 as a polymer base, and the tensile strength at break of the heat-recoverable conductive composite shield is between 4 MPa and 10 MPa (for example, between 6 MPa and 8 MPa as shown in m-LLDPE plots 306 of FIG. 3) and/or the tensile elongation at break is between 400% and 600% (for example, between 450% and 500% as shown in FIG. 3).

Suitable non-conductive matrices include, but are not limited to, the PVDF, copolymers of vinylidene fluoride (VDF) and hexafluoropropylene (HFP), terpolymers of VDF, HFP and tetrafluoroethylene (TFE), fluorinated ethylene propylene, ethylene tetrafluoroethylene, polytetrafluoroethylene, other suitable fluorinated matrices compatible with the conductive particles, or a combination thereof. Other suitable non-conductive matrices include, but are not limited to the polyethylene (for example, high, medium, low, and/or linear low density polyethylene, such as, metallocene-catalyzed polyethylene (m-LLDPE)), polypropylene, ethylene-vinyl acetate, polyamide, neoprene, or a combination thereof.

In one embodiment, the non-conductive matrix has a crystallinity within a specific range, for example, between 15% and 65%, between 15% and 35%, between 15% and 20%, between 18% and 19%, between 30% and 35%, between 32% and 34%, or any suitable combination, sub-combination, range, or sub-range therein.

In addition to the non-conductive matrix and the conductive particles, the heat-recoverable conductive composite shield 103 includes any other suitable constituents. For example, in one embodiment, the heat-recoverable conductive composite shield 103 includes a sebacate-type of plasticizer, for example, at a volume concentration of between 5% and 10% (for example, 7.5%). In one embodiment, the heat-recoverable conductive composite shield 103 includes a process aid for facilitating filler dispersion and increasing processability in a homogenous or substantially homogenous manner. The heat-recoverable conductive composite shield 103 includes or is devoid of a crosslinking agent or crosslinking agents, an antioxidant, a metal deactivator, a flame retardant, and/or a coupling agent.

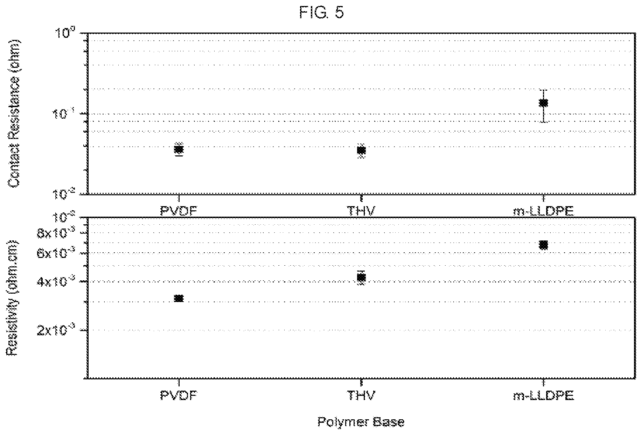

Suitable resistivity values of the conductive heat-recoverable composite shield 103 include being less than 0.05 ohm·cm, for example, being less than 0.01 ohm·cm, being between 0.0005 ohm·cm and 0.05 ohm·cm, or being between 0.0005 ohm·cm and 0.01 ohm·cm, depending upon the concentration of the conductive particles and the types of the non-conductive matrices. As used herein, the term "resistivity" refers to measurable values determined upon extrusion and/or full recovery and does not refer to values measured while in an expanded state. For example, FIG. 5 shows resistivity and contact resistance for embodiments of the conductive heat-recoverable composite shield 103, with the conductive heat-recoverable composite shield including the PVDF as the polymer base, THV as the polymer base, or m-LLDPE as the polymer base.

The conductive heat-recoverable composite shield 103 has a thickness, for example, of between 0.2 mm and 2 mm, 0.4 mm and 1.6 mm, 0.5 mm, 1 mm, 1.5 mm, or any suitable combination, sub-combination, range, or sub-range therein. Other suitable thickness of the conductive heat-recoverable composite shield 103 include, but are not limited to, between 0.07 mm and 0.5 mm, between 0.1 mm and 0.5 mm, between 0.2 mm and 0.5 mm, greater than 0.1 mm, greater than 0.2 mm, greater than 0.4 mm, or any suitable combination, sub-combination, range, or sub-range therein.

In one embodiment, the conductive heat-recoverable composite shield 103 is compatible with soldering. For example, the loading/concentration of the conductive particles is at a suitable amount such that soldering material, such as soldering paste, is able wet sufficiently on the conductive heat-recoverable composite shield 103, thereby permitting a suitable soldering joint to be formed.

In one embodiment, the conductive heat-recoverable composite shield 103 and, thus, the heat-recovered composite shield 101 each include the conductor 107 at least partially surrounded by the conductive heat-recoverable composite shield 101 or the conductive heat-recovered composite shield 101, a dielectric material positioned as the inner layer 109 being at least partially surrounded by the outer layer 111 of the conductive heat-recoverable composite shield 101 or the conductive heat-recovered composite shield 101, a jacket material (not shown) at least partially surrounding the outer layer 111 or the conductive heat-recoverable composite shield 101 or the conductive heat-recovered composite shield 101, or a combination thereof. In a further embodiment, the dielectric material is devoid or substantially devoid of the conductive particles and includes the same type polymer matrix material as the conductive heat-recoverable composite shield 101 or another suitable species of the polymer matrix materials.

Unlike a homogeneous metal shield, the DC resistivity of the conductive composite shield does not completely predict the shielding effectiveness of the material. These conductive composite materials typically have much greater shielding effectiveness than would be expected, especially at frequencies greater than 1 GHz. Thus, a resistivity as high as 0.05 ohm-cm compared to metals in the 1x10⁻⁶ ohm cm range, can still give adequate shielding performance. In addition, using the conductive composite shield plus a metal braided or wrapped shield is synergistic. The metal shield has good low frequency shielding (i.e. in the KHz to 1 GHz range), but shielding effectives decreases at higher frequencies. The conductive composite shields described herein tend to have the opposite behavior. In addition, combining a metal braid with a conductive composite shield allows the use of conventional connectors and termination methods.

## Claims

1. An article, comprising:
a conductive heat-recoverable composite shield (103);
wherein the conductive composite shield comprises a non-conductive matrix and conductive particles within the non-conductive matrix; and
wherein the article has a resistivity of less than 0.05 ohm·cm;
**characterised in that**:
the conductive particles have a morphology of dendrites, flakes or spheres.

2. The article of claim 1, wherein the conductive heat-recoverable composite shield (103) has been expanded after electron beaming within a range of 3 Mrad and 15 Mrad.

3. The article of claim 1, wherein the article has a resistivity of between 0.0005 ohm·cm and 0.05 ohm·cm.

4. The article of claim 1, further comprising at least one of
(a) a conductor (107) at least partially surrounded by the conductive heat-recoverable composite shield (111);
(b) a dielectric material (109) at least partially surrounded by the conductive heat-recoverable composite shield (111).

5. The article of claim 1, further comprising a jacket material at least partially surrounding the conductive heat-recoverable composite shield (111), preferably wherein the jacket and the conductive heat-recoverable composite shield are a dual-wall co-extrusion or a tandem-extrusion.

6. The article of claim 1, wherein the conductive heat-recoverable composite shield (103) is an extruded article or an injection molded article.

7. The article of claim 1, wherein the article is a heat-recoverable tube, a heat-recoverable sheet, a heat-recoverable end cap, or a heat-recoverable tape.

8. The article of claim 1, wherein the conductive particles include particles selected from the group consisting of copper particles, tin particles, nickel particles, aluminum particles, carbon particles, carbon black, carbon nanotubes, graphene, silver-coated particles, nickel-coated particles, or a combination thereof.

9. The article of claim 1, wherein the non-conductive matrix includes material selected from the group consisting of polyvinylidene fluoride, copolymers of vinylidene fluoride (VDF) and hexafluoropropylene (HFP), terpolymers of VDF, HFP and tetrafluoroethylene (TFE), fluorinated ethylene propylene, ethylene tetrafluoroethylene, polyethylene (PE), polypropylene, ethylene-vinyl acetate, polyamide, neoprene, and combinations thereof.

10. The article of claim 1, wherein the conductive heat-recoverable composite shield (103) has a thickness of at least 0.07 mm.

11. An article, comprising:
a conductive heat-recovered composite shield (101) formed from a conductive heat-recoverable composite shield (103);
wherein the heat-recoverable conductive composite shield comprises a non-conductive matrix and conductive particles within the non-conductive matrix;
wherein the article has a resistivity of less than 0.05 ohm·cm;
**characterised in that**:
the conductive particles have a morphology of dendrites, flakes or spheres.

12. A process (100) of producing a conductive heat-recovered composite shield (101), the process comprising:
extruding (102) a conductive heat-recoverable composite shield (103); and
heating (104) the conductive heat-recoverable composite shield thereby forming the conductive heat-recovered composite shield;
wherein the heat-recoverable conductive composite shield comprises a non-conductive matrix and conductive particles within the non-conductive matrix;
**characterised in that**:
the conductive particles have a morphology of dendrites, flakes or spheres.

13. A process (100) of claim 12, wherein the extruding is a co-extruding of the conductive heat-recoverable composite shield and a jacket material.

## Patentansprüche

1. Artikel, der Folgendes umfasst:
eine leitfähige, wärmeschrumpfbare Verbundstoffabschirmung (103);
wobei die leitfähige Verbundstoffabschirmung eine nicht leitfähige Matrix und leitfähige Partikel innerhalb der nicht leitfähigen Matrix umfasst; und
wobei der Artikel eine Resistivität von weniger als 0,05 Ohm·cm hat;
**dadurch gekennzeichnet, dass**:
die leitfähigen Partikel eine Morphologie von Dendriten, Flocken oder Kugeln haben.

2. Artikel nach Anspruch 1, wobei die leitfähige, wärmeschrumpfbare Verbundstoffabschirmung (103) nach dem Elektronenstrahlen in einem Bereich von 3 Mrad und 15 Mrad expandiert wurde.

3. Artikel nach Anspruch 1, wobei der Artikel eine Resistivität zwischen 0,0005 Ohm·cm und 0,05 Ohm·cm hat.

4. Artikel nach Anspruch 1, der ferner wenigstens eines der Folgenden umfasst:
(a) einen Leiter (107), der wenigstens teilweise von der leitfähigen wärmeschrumpfbaren Verbundstoffabschirmung (111) umgeben ist;
(b) ein dielektrisches Material (109), das wenigstens teilweise von der leitfähigen wärmeschrumpfbaren Verbundstoffabschirmung (111) umgeben ist.

5. Artikel nach Anspruch 1, der ferner ein Mantelmaterial umfasst, das die leitfähige wärmeschrumpfbare Verbundstoffabschirmung (111) wenigstens teilweise umgibt, wobei vorzugsweise der Mantel und die leitfähige wärmeschrumpfbare Verbundstoffabschirmung eine Doppelwand-Coextrusion oder eine Tandem-Extrusion sind.

6. Artikel nach Anspruch 1, wobei die leitfähige wärmeschrumpfbare Verbundstoffabschirmung (103) ein extrudierter Artikel oder ein spritzgeformter Artikel ist.

7. Artikel nach Anspruch 1, wobei der Artikel ein wärmeschrumpfbarer Schlauch, eine wärmeschrumpfbare Folie, eine wärmeschrumpfbare Endkappe oder ein wärmeschrumpfbares Band ist.

8. Artikel nach Anspruch 1, wobei die leitfähigen Partikel Partikel beinhalten, ausgewählt aus der Gruppe bestehend aus Kupferpartikeln, Zinnpartikeln, Nickelpartikeln, Aluminiumpartikeln, Kohlepartikeln, Ruß, Kohlenstoffnanoröhrchen, Graphen, silberbeschichteten Partikeln, nickelbeschichteten Partikeln oder einer Kombination davon.

9. Artikel nach Anspruch 1, wobei die nicht leitfähige Matrix Material beinhaltet, ausgewählt aus der Gruppe bestehend aus Polyvinylidenfluorid, Copolymeren von Vinylidenfluorid (VDF) und Hexafluorpropylen (HFP), Terpolymeren von VDF, HFP und Tetrafluorethylen (TFE), fluoriniertem Ethylenpropylen, Ethylentetrafluorethylen, Polyethylen (PE), Polypropylen, Ethylenvinylacetat, Polyamid, Neopren und Kombinationen davon.

10. Artikel nach Anspruch 1, wobei die leitfähige wärmeschrumpfbare Verbundstoffabschirmung (103) eine Dicke von wenigstens 0,07 mm hat.

11. Artikel, der Folgendes umfasst:
eine leitfähige wärmegeschrumpfte Verbundstoffabschirmung (101), die von einer leitfähigen wärmeschrumpfbaren Verbundstoffabschirmung (103) gebildet ist;
wobei die wärmeschrumpfbare leitfähige Verbundstoffabschirmung eine nicht leitfähige Matrix und leitfähige Partikel innerhalb der nicht leitfähigen Matrix umfasst;
wobei der Artikel eine Resistivität von weniger als 0,05 Ohm·cm hat;
**dadurch gekennzeichnet, dass**:
die leitfähigen Partikel eine Morphologie von Dendriten, Flocken oder Kugeln haben.

12. Verfahren (100) zum Produzieren einer leitfähigen wärmegeschrumpften Verbundstoffabschirmung (101), wobei das Verfahren Folgendes beinhaltet:
Extrudieren (102) einer leitfähigen wärmeschrumpfbaren Verbundstoffabschirmung (103); und
Erhitzen (104) der leitfähigen wärmeschrumpfbaren Verbundstoffabschirmung, um dadurch die leitfähige wärmegeschrumpfte Verbundstoffabschirmung zu bilden;
wobei die wärmeschrumpfbare leitfähige Verbundstoffabschirmung eine nicht leitfähige Matrix und leitfähige Partikel innerhalb der nicht leitfähigen Matrix umfasst;
**dadurch gekennzeichnet, dass**:
die leitfähigen Partikel eine Morphologie von Dendriten, Flocken oder Kugeln haben.

13. Verfahren (100) nach Anspruch 12, wobei das Extrudieren ein Coextrudieren der leitfähigen wärmeschrumpfbaren Verbundstoffabschirmung und eines Mantelmaterials ist.

## Revendications

1. Article, comprenant :
un blindage composite thermorétractable conducteur (103) ;
dans lequel le blindage composite conducteur comprend une matrice non conductrice et des particules conductrices dans la matrice non conductrice ; et
dans lequel l'article a une résistivité de moins de 0,05 ohm·cm ;
**caractérisé en ce que** :
les particules conductrices ont une morphologie de dendrites, flocons ou sphères.

2. Article selon la revendication 1, dans lequel le blindage composite thermorétractable conducteur (103) a été expansé après projection de faisceau d'électrons dans une plage de 3 Mrad et 15 Mrad.

3. Article selon la revendication 1, dans lequel l'article a une résistivité entre 0,0005 ohm·cm et 0,05 ohm·cm.

4. Article selon la revendication 1, comprenant au moins un
(a) d'un conducteur (107) entouré au moins partiellement par le blindage composite thermorétractable conducteur (111) ;
(b) d'un matériau diélectrique (109) entouré au moins partiellement par le blindage composite thermorétractable conducteur (111).

5. Article selon la revendication 1, comprenant en outre un matériau de chemise entourant au moins partiellement le blindage composite thermorétractable conducteur (111), de préférence dans lequel la chemise et le blindage composite thermorétractable conducteur sont une co-extrusion à double paroi ou une extrusion tandem.

6. Article selon la revendication 1, dans lequel le blindage composite thermorétractable conducteur (103) est un article extrudé ou un article moulé par injection.

7. Article selon la revendication 1, dans lequel l'article est un tube thermorétractable, une feuille thermorétractable, un embout thermorétractable, ou un ruban thermorétractable.

8. Article selon la revendication 1, dans lequel les particules conductrices comportent des particules sélectionnées dans le groupe consistant en particules de cuivre, particules d'étain, particules de nickel, particules d'aluminium, particules de carbone, noir de charbon, nanotubes de charbon, graphène, particules revêtues d'argent, particules revêtues du nickel, ou une combinaison de ceux-ci.

9. Article selon la revendication 1, dans lequel la matrice non conductrice comporte un matériau sélectionné dans le groupe consistant en fluorure de polyvinylidène, copolymères de fluorure de vinylidène (VDF) et hexafluoropropylène (HFP), terpolymères de VDF, HFP et tétrafluoroéthylène (TFE), propylène d'éthylène fluoré, éthylène tétrafluoroéthylène, polyéthylène (PE), polypropylène, acétate d'éthylène-vinyle, polyamide, néoprène, et des combinaisons de ceux-ci.

10. Article selon la revendication 1, dans lequel le blindage composite thermorétractable conducteur (103) a une épaisseur d'au moins 0,07 mm.

11. Article, comprenant :
un blindage composite thermorétracté conducteur (101) formé à partir d'un blindage composite thermorétractable conducteur (103) ;
dans lequel le blindage composite thermorétractable conducteur comprend une matrice non conductrice et des particules conductrices dans la matrice non conductrice ; et
dans lequel l'article a une résistivité de moins de 0,05 ohm·cm ;
**caractérisé en ce que** :
les particules conductrices ont une morphologie de dendrites, flocons ou sphères.

12. Processus (100) de production d'un blindage composite thermorétracté conducteur (101), le processus comprenant :
l'extrusion (102) d'un blindage composite thermorétractable conducteur (103); et
le chauffage (104) du blindage composite thermorétractable conducteur formant ainsi le blindage composite thermorétracté conducteur ;
dans lequel le blindage composite thermorétractable conducteur comprend une matrice non conductrice et des particules conductrices dans la matrice non conductrice ;
**caractérisé en ce que** :
les particules conductrices ont une morphologie de dendrites, flocons ou sphères.

13. Processus (100) selon la revendication 12, dans lequel l'extrusion est une co-extrusion du blindage composite thermorétractable conducteur et d'un matériau de chemise.
